# EUROPEAN PATENT APPLICATION

(11) **EP 3 425 409 A1**
(43) Date of publication of application: **09.01.2019**
(21) Application number: 16892694.7
(22) Date of filing: 22.11.2016
(51) Int. Cl.: G01R 31/02, G01R 31/08, H02H 3/00, H02S 50/00

(54) **ARCING POSITION DETECTION DEVICE AND ARCING POSITION DETECTION METHOD**

(30) Priority: 29.02.2016 JP 2016036879
(71) Applicant: Omron Corporation, Kyoto-shi, Kyoto 600-8530 (JP)
(72) Inventor: ASHIDA, Takeshi, Kyoto-shi Kyoto 600-8530 (JP); TOMITA, Kohei, Kyoto-shi Kyoto 600-8530 (JP)
(74) Representative: Becker Kurig Straus
(86) International application number: PCT/JP2016/084645
(87) International publication number: WO 2017/149859

(57) **Abstract**

In order to identify an arcing position in a DC power source, this arcing position detection device (15) is provided with an arc detection unit (31) which detects arcing in a solar battery string (11), a break position detection unit (32) which detects a break position in the solar battery string (11), and a main control unit (33) which, when arcing has occurred, outputs the break position detected by the break position detection unit (32) as the arcing position.

## Description

### [Technical Field]

The present invention relates to an arc occurrence position detection device and an arc occurrence position detection method which are used in a DC power source system.

### [Background Art]

Generally, a photovoltaic power generation system includes a solar battery string as a DC power source in which a plurality of solar battery modules are connected in series, and a power conditioner which converts the DC power output from the solar battery string into AC power.

In the photovoltaic power generation system, a DC arc and a parallel arc may be generated, and the occurrence of such an arc causes fire of the photovoltaic power generation system. Therefore, when such an arc is generated, it is necessary to extinguish the arc, and furthermore, it is necessary to repair the location where the arc is generated so as to prevent reoccurrence of the arc. Specifically, when an arc is generated at a cable serving as a power line of the solar battery string, the cable needs to be replaced.

Among arcs, series arcs are easily generated due to disconnection of a cable or the like and can be extinguished by opening an arc cutoff switch provided in the power line between the solar battery string and the power conditioner.

Conventionally, in a photovoltaic power generation system, a device for detecting the occurrence of an arc and a device for specifying the arc occurrence position when the arc occurs are used due to the necessity of the above-mentioned correspondence to the arc.

For example, in a photovoltaic power generation system disclosed in Patent Literature 1, a plurality of photovoltaic power generation panels are connected in parallel to a DC bus via a first switch provided to correspond to each photovoltaic power generation panel, and the DC bus is connected to the power conditioner through a second switch. Therefore, in the configuration of Patent Literature 1, the arc occurrence position is specified from a voltage difference between same polarity terminals of the first switch and the second switch and a voltage difference between opposite polarity terminals thereof.

In a photovoltaic power generation system disclosed in Patent Literature 2, a plurality of solar battery strings are connected to a power conditioner via a connection box. The connection box has a structure in which external light does not enter and includes a light sensor and a switch provided in each of the plurality of solar battery strings and connected in series with the solar battery string. Therefore, in the configuration of Patent Literature 2, when the light sensor detects light due to an arc, the switches are sequentially opened and closed, and when the arc is extinguished while a switch is opened, it is determined that the arc is generated in the solar battery string connected to the switch.

### [Citation List]

### [Patent Literature]

[Patent Literature 1]
   Japanese Unexamined Patent Application Publication No. 2013-132157 (published on July 4, 2013)
[Patent Literature 2]
   Japanese Unexamined Patent Application Publication No. 2014-42364 (published on March 6, 2014)
[Patent Literature 3]
   U.S. Patent Application Publication No. US2012-0316804A1 (published on December 13, 2012)
[Patent Literature 4]
   Japanese Unexamined Patent Application Publication No. 2013-156125 (published on August 15, 2013)
[Patent Literature 5]
   Japanese Patent No. 5196607 (issued on May 15, 2013)
[Patent Literature 6]
   Japanese Patent No. 4604250 (issued on January 5, 2011)

### [Summary of Invention]

### [Technical Problem]

However, in the configuration disclosed in Patent Literature 1, when the photovoltaic power generation panel is used as a DC power source like a general photovoltaic power generation system, although it is possible to specify the DC power source where the arc has occurred, it is not possible to know where the arc is generated in the DC power source, and it is not possible to specify the arc occurrence position.

In the configuration disclosed in Patent Literature 2, like the configuration described in Patent Literature 1, although it is possible to specify the DC power source where the arc has occurred, it is not possible to known where the arc is generated in the DC power source, and thus it is not possible to specify the arc occurrence position.

Therefore, an object of the present invention is to provide an arc occurrence position detection device and an arc occurrence position detection method capable of detecting occurrence of an arc at a DC power source such as a solar battery string or the like and capable of specifying an arc occurrence position at the DC power source.

### [Solution to Problem]

An arc occurrence position detection device according to one aspect of the present invention is an arc detection device applied to a DC power source system which includes a DC power source configured to generate electric power or to charge and discharge, a load device configured to convert or consume DC power supplied from the DC power source, and an output line configured to connect the DC power source and the load device, the arc occurrence position detection device including an arc detection unit configured to detect occurrence of an arc at at least one of the DC power source and the output line, a disconnection position detection unit configured to detect a disconnection position at the DC power source, and a control unit configured to operate the disconnection position detection unit when the arc detection unit detects the arc and output a disconnection position detected by the disconnection position detection unit as an arc occurrence position.

An arc occurrence position detection method according to one aspect of the present invention is an arc detection method applied to a DC power source system which includes a DC power source configured to generate electric power or to charge and discharge, a load device configured to convert or consume DC power supplied from the DC power source, and an output line configured to connect the DC power source and the load device, the method including an arc detection process of detecting occurrence of an arc at at least one of the DC power source and the output line, and a disconnection position detection process of detecting a disconnection position at the DC power source when the arc is detected by the arc detection process and setting the detected disconnection position as an arc occurrence position.

### [Advantageous Effects of Invention]

According to a configuration according to one aspect of the present invention, it is possible to detect occurrence of a series arc at a DC power source and also to appropriately specify an occurrence position of the series arc at the DC power source.

### [Brief Description of Drawings]

Fig. 1 is a schematic block diagram illustrating a configuration of a photovoltaic power generation system including an arc detection device according to an embodiment of the present invention.
Fig. 2 is a block diagram illustrating an example of an arc detection unit illustrated in Fig. 1.
Fig. 3 is a block diagram illustrating an example of a configuration of a disconnection position detection unit illustrated in Fig. 1.
Fig. 4 is a flowchart illustrating an operation of an arc occurrence position detection device illustrated in Fig. 1.
Fig. 5 is a schematic circuit diagram illustrating a disconnection position detection operation of a solar battery string performed by the disconnection position detection unit illustrated in Fig. 3.

### [Description of Embodiments]

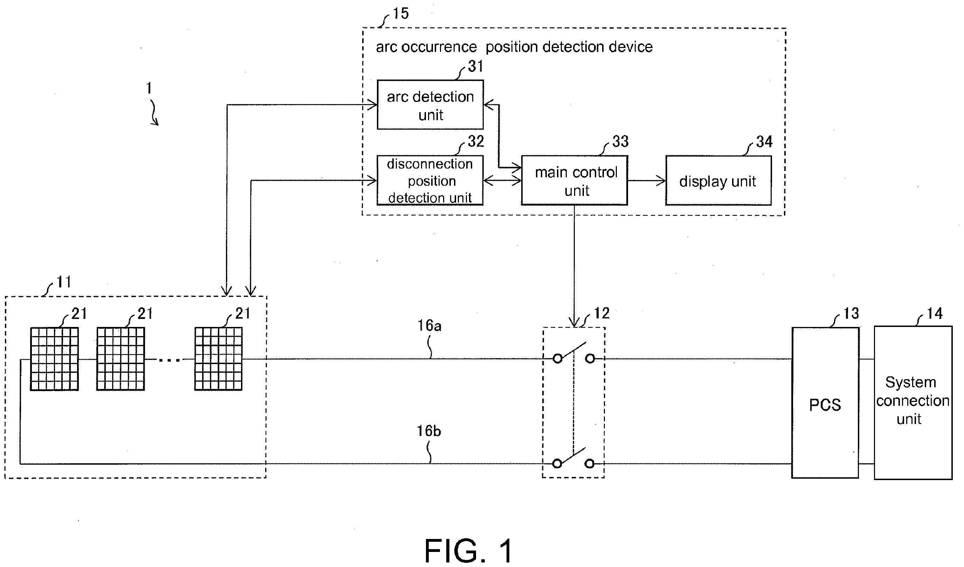

Embodiments of the present invention will be described below with reference to the drawings. Fig. 1 is a schematic block diagram illustrating a configuration of a photovoltaic power generation system including an arc detection device according to an embodiment of the present invention.

### (Configuration of photovoltaic power generation system 1)

As illustrated in Fig. 1, a photovoltaic power generation system (DC power source system) 1 includes a solar battery string (DC power source) 11, an arc cutoff switch 12, a power conditioning system (hereinafter, simply referred to as a PCS (power conditioning system)) 13, a system connection unit 14 and an arc occurrence position detection device 15.

The solar battery string 11 is formed by connecting a plurality of solar battery modules 21 in series. Each of the solar battery modules 21 includes a plurality of solar cells (not illustrated) connected in series and is formed in a panel shape. Such a solar battery string 11 is connected to the PCS (load device) 12 via a P-side output line 16a and an N-side output line 16b.

The arc cutoff switch 12 is provided in the output lines 16a and 16b between the solar battery string 11 and the PCS 13 and is controlled by the arc occurrence position detection device 15 to cut off the output lines 16a and 16b when a series arc is generated. Therefore, the series arc is extinguished.

The PCS 13 converts DC power input from the solar battery string 11 into AC power and outputs it to the system connection unit 14. The system connection unit 14 performs system connection between a power system of the photovoltaic power generation system 1 and a power system of a commercial power source.

### (Configuration of arc occurrence position detection device 15)

The arc occurrence position detection device 15 includes an arc detection unit 31, a disconnection position detection unit 32, a main control unit 33 and a display unit 34.

The arc detection unit 31 is configured to detect presence or absence of occurrence of an arc in the solar battery string 11 and has, for example, a configuration of a conventionally well-known arc detection device.

The disconnection position detection unit 32 is configured to detect a disconnection position of the solar battery string 11 through a disconnection position detection operation, and has, for example, a configuration of a conventionally well-known disconnection position detection device.

The main control unit 33 controls operations of the arc detection unit 31 and the disconnection position detection unit 32 and an opening and closing operation of the arc cutoff switch 12.

The display unit 34 is configured with, for example, a liquid crystal display device and displays a variety of information under the control of the main control unit 33.

### (Detection principle of arc occurrence position by arc occurrence position detection device 15)

Here, a detection principle of the arc occurrence position by the arc occurrence position detection device 15 will be described. The series arc is usually generated when, for example, a cable forming a power line of the solar battery string 11 is disconnected from a connected state and conductors are separated from each other. Therefore, if the disconnection position of the power line can be specified, it is considered that the arc occurrence position can be specified. Thus, in the arc occurrence position detection device 15, the arc detection unit 31 monitors the presence or absence of the arc in the solar battery string 11, the arc detection unit 31 detects the arc, and when the arc is the series arc, the disconnection position detection unit 32 detects the disconnection position of the solar battery string 11 and sets the detected disconnection position as the arc occurrence position.

### (Arc detection unit 31)

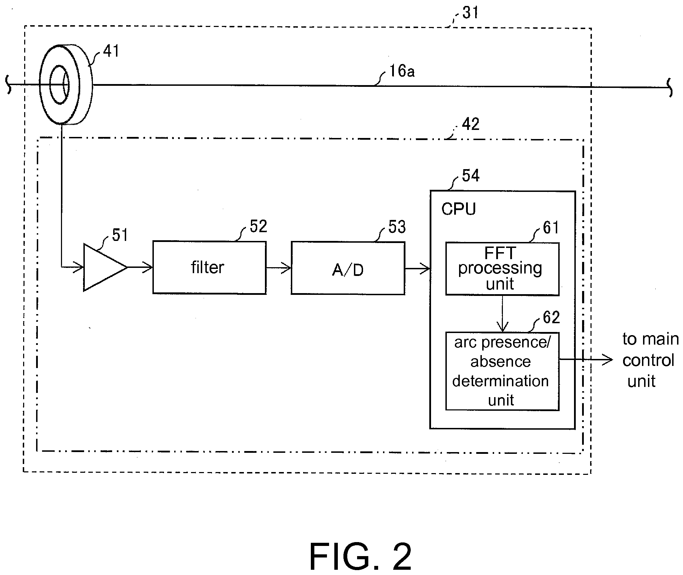

Fig. 2 is a block diagram illustrating an example of the arc detection unit 31 illustrated in Fig. 1. As illustrated in Fig. 2, the arc detection unit 31 includes a current sensor 41 and an arc detection processing unit 42.

The current sensor 41 is provided, for example, in the output line 16a and detects a current flowing through the output line 16a.

The arc detection processing unit 42 has, for example, a conventionally well-known configuration as disclosed in Patent Literature 2 and includes, for example, an amplifier 51, a filter 52, an A/D conversion unit 53 and a central processing unit (CPU) 54.

The amplifier 51 amplifies a current detected by the current sensor 41. The filter 52 is a band pass filter (BPF) and passes only a current in a predetermined frequency range of the current output from the amplifier 51. Accordingly, a current having a frequency component containing a large amount of switching noise of a converter (DC-DC converter) of the PCS 13 can be excluded from the current output from the amplifier 51. The A/D conversion unit 53 converts an analog signal of the current having passed through the filter 52 into a digital signal and then inputs the converted digital signal to the CPU 54.

The CPU 54 includes an FFT processing unit 61 and an arc presence/absence determination unit 62. The FFT processing unit 61 performs an FFT on the digital signal of the current input from the A/D conversion unit 53 and generates a power spectrum of the current. The arc presence/absence determination unit 62 determines whether or not an arc is generated on the basis of the power spectrum of the current generated by the FFT processing unit 61.

### (Disconnection position detection unit 32)

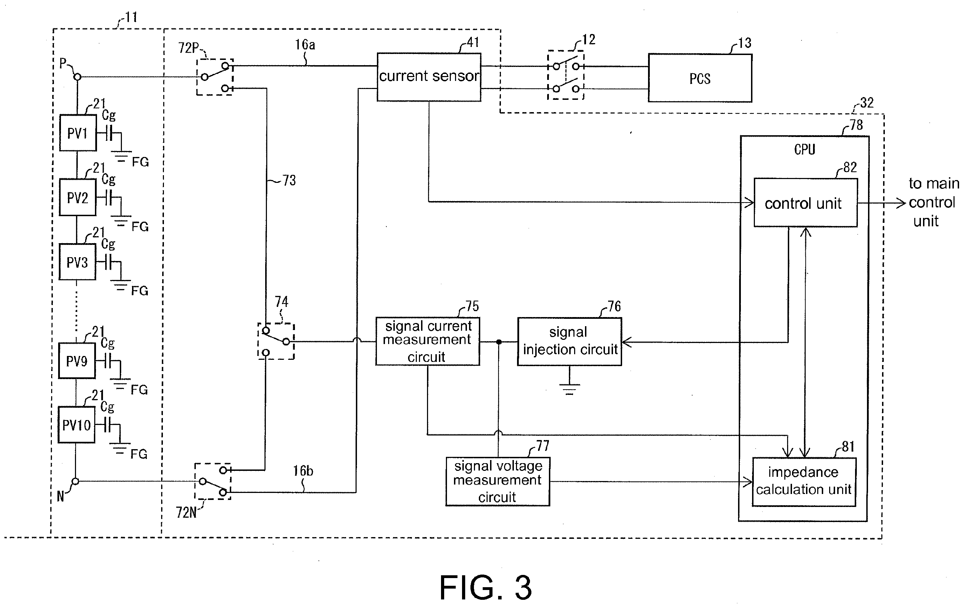

Fig. 3 is a block diagram illustrating an example of a configuration of the disconnection position detection unit 32 illustrated in Fig. 1. Fig. 3 illustrates a case in which the solar battery string 11 is formed by connecting 10 solar battery modules 21 (PV1 to PV10) in series. A ground capacitance Cg is generated between each of the solar battery modules 21 and the ground.

As illustrated in Fig. 3, the disconnection position detection unit 32 includes a current sensor 41, switching relays 72P and 72N, an inspection energization passage 73, a switching relay 74, a signal current measurement circuit 75, a signal injection circuit 76, a signal voltage measurement circuit 77 and a CPU 78. Further, in the example of Fig. 3, the disconnection position detection unit 32 is configured to share the current sensor 41 of the arc detection unit 31, but the disconnection position detection unit 32 may have a current sensor separated from that of the arc detection unit 31.

The switching relays 72P and 72N switch a supply passage of the power output from the solar battery string 11 between the PCS 13 side and the inspection energization passage 73 side. The switching relay 74 is provided in the inspection energization passage 73 and switches connection of an input terminal of the signal current measurement circuit 75 between the P terminal side and the N terminal side of the solar battery string 11.

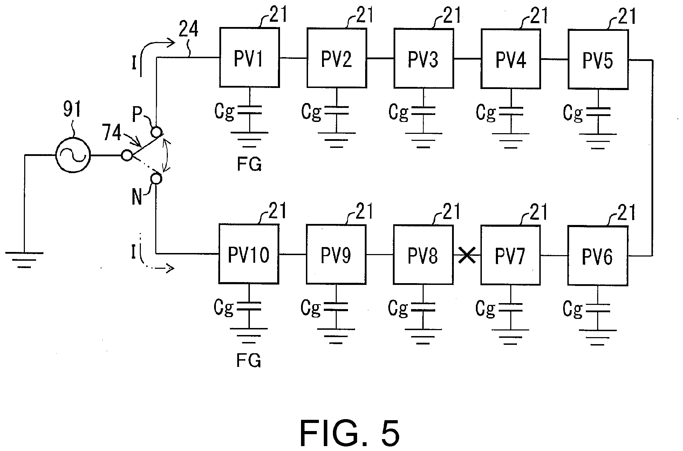

The signal injection circuit 76 supplies an AC inspection signal 91 (refer to Fig. 5) which is injected into the solar battery string 11 to the P terminal of the solar battery string 11 via the switching relay 74 and the switching relay 72P. Further, the inspection signal is supplied to the N terminal of the solar battery string 11 via the switching relay 74 and the switching relay 72N.

In a state in which the inspection signal 91 is supplied from the signal injection circuit 76 to the P terminal of the solar battery string 11 (hereinafter referred to as application of the inspection signal to the P terminal), the signal current measurement circuit 75 measures the inspection signal current flowing through the solar battery string 11. Further, in a state in which the inspection signal 91 is supplied from the signal injection circuit 76 to the N terminal of the solar battery string 11 (hereinafter referred to as application of the inspection signal to the N terminal), the inspection signal current flowing through the solar battery string 11 is measured. The signal current measurement circuit 75 outputs a measurement result to an impedance calculation unit 81 of the CPU 78. The signal voltage measurement circuit 77 measures a voltage (inspection signal voltage) of the inspection signal 91 in the case of the application of the inspection signal to the P terminal and the case of the application of the inspection signal to the N terminal and then outputs a measurement result to the impedance calculation unit 81 of the CPU 78.

The CPU 78 includes the impedance calculation unit 81 and a control unit 82. The impedance calculation unit 81 obtains an impedance in the solar battery string 11 in the case of the application of the inspection signal to the P terminal and the case of the application of the inspection signal to the N terminal on the basis of data input from the signal current measurement circuit 75 and the signal voltage measurement circuit 77.

The control unit 82 detects the presence or absence of the disconnection of the cable or the like in the solar battery string 11 and the disconnection position in the case in which the disconnection occurs from the impedance in the solar battery string 11 in the case of the application of the inspection signal to the P terminal and the impedance in the case of the application of the inspection signal to the N terminal, which are obtained by the impedance calculation unit 81. Further, the disconnection determined by the control unit 82 also includes disconnection of the solar battery module 21.

### (Operation of arc occurrence position detection device 15)

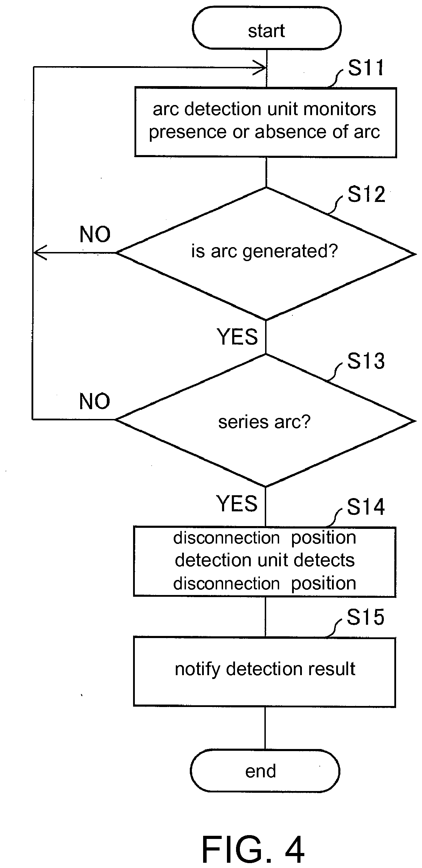

An operation of the arc occurrence position detection device 15 in the above-described configuration will be described below. Fig. 4 is a flowchart illustrating the operation of the arc occurrence position detection device 15 illustrated in Fig. 1.

As illustrated in Fig. 4, the arc detection unit 31 of the arc occurrence position detection device 15 monitors the presence or absence the arc in the solar battery string 11 (S11).

After that, when the occurrence of the arc in the solar battery string 11 is detected (S12), the arc detection unit 31 notifies the main control unit 33 of that fact. The main control unit 33 causes the display unit 34 to display the fact that the arc has occurred in the solar battery string 11. The main control unit 33 may notify a management device (not illustrated) of the photovoltaic power generation system 1 that the arc has occurred.

Further, when the arc detection unit 31 detects the occurrence of the arc, the main control unit 33 opens the arc cutoff switch 12. Therefore, if the arc detected by the arc detection unit 31 is extinguished, the main control unit 33 determines that the arc is a series arc (S13) and causes the display unit 34 to display that fact. On the other hand, if the arc detected by the arc detection unit 31 is not extinguished, the main control unit 33 determines that the arc is a parallel arc (S13) and causes the display unit 34 to display that fact. Also, the parallel arc can be extinguished by short-circuiting the output lines 16a and 16b.

Next, when the arc is the series arc, the main control unit 33 activates the disconnection position detection unit 32. Therefore, the disconnection position detection unit 32 performs a detection operation of the disconnection position in the solar battery string 11 (S14). In this case, the arc cutoff switch 12 is in an open state.

The disconnection position detection unit 32 notifies the main control unit 33 of information indicating the disconnection position upon detecting the disconnection position in the solar battery string 11. The main control unit 33 causes the display unit 34 to display the detected disconnection position as the arc occurrence position upon receiving this notification (S15). In this case, the main control unit 33 may notify the management device of the photovoltaic power generation system 1 of the content to be displayed on the display unit 34.

### (Specific operation of disconnection position detection unit 32)

Fig. 5 is a schematic circuit diagram illustrating a disconnection position detection operation of the solar battery string 11 due to the disconnection position detection unit 32. The example of Fig. 5 illustrates a state in which the cable between the seventh solar battery module 21 (PV7) and the eighth solar battery module 21 (PV8) as seen from the P terminal side is disconnected.

First, the disconnection position detection unit 32 determines the presence or absence of the disconnection in the solar battery string 11. If the disconnection occurs in the solar battery string 11, an output current of the solar battery string 11 measured by the current sensor 41 is approximately 0 A. Therefore, the control unit 82 of the CPU 78 can determine from the output current of the solar battery string 11 measured by the current sensor 41 that there is a disconnection in the solar battery string 11.

Further, when the disconnection of the solar battery string 11 is detected on the basis of a current value detected by the current sensor 41, the current sensor 41 detects the output current of the solar battery string 11 before the arc cutoff switch 12 is in the open state.

Further, the presence or absence of the disconnection in the solar battery string 11 may be detected by a voltage sensor which measures a voltage between the PN terminals of the solar battery string 11. When the disconnection of the cable occurs, the voltage between the PN terminals measured by the voltage sensor is almost 0 V.

When it is determined that there is a disconnection in the solar battery string 11, the disconnection position detection unit 32 detects the disconnection position of the solar battery string 11 through the disconnection position detection operation. In this case, the disconnection position detection unit 32 obtains an impedance Zp of the solar battery string 11 in the case of the application of the inspection signal to the P terminal and an impedance Zn of the solar battery string 11 in the case of the application of the inspection signal to the N terminal.

Further, when the solar battery string 11 is in a power generation state, the solar battery module 21 is in state in which only a series resistance Rs having a very small value, for example, 1 Ω or less, is included. Furthermore, an inductance L also has a very small value with respect to the capacitance-to-ground Cg. Therefore, when the solar battery string 11 is in the power generation state, the impedances Zp and Zn can be obtained accurately.

When the impedance Zp is obtained, the switching relay 74 is switched to apply the inspection signal 91 to the P terminal of the solar battery string 11 (application of the inspection signal to the P terminal). The impedance calculation unit 81 obtains the impedance Zp from an inspection signal current obtained from the signal current measurement circuit 75 and an inspection signal voltage obtained from the signal voltage measurement circuit 77 in this case.

Similarly, when the impedance Zn is obtained, the switching relay 74 is switched to apply the inspection signal 91 to the N terminal of the solar battery string 11 (application of the inspection signal to the N terminal). The impedance calculation unit 81 obtains the impedance Zn from the inspection signal current obtained from the signal current measurement circuit 75 and the inspection signal voltage obtained from the signal voltage measurement circuit 77 in this case. Also, an impedance analyzer may be used for impedance measurement.

In this case, the impedance indicating the disconnection position of the solar battery string 11 decreases when the disconnection is further from a position of the terminal (the P terminal and the N terminal) to which the inspection signal 91 is applied. Therefore, the control unit 82 obtains the disconnection position by calculating a ratio between Zn/(Zp+Zn) and Zp/(Zp+Zn).

Also, even in the case in which the solar battery module 21 of the solar battery string 11 or the like has failed and a failure point has high resistance, a failure position (the failed solar battery module 21) can be detected by the same method as described above.

According to the configuration of the disconnection position detection unit 32 as described above, there is no need to measure the impedance of the solar battery string 11 in advance in a state in which no disconnection occurs, and it is also possible to obtain the disconnection position of the solar battery string 11 without using the impedance measured in advance, which changes daily due to weather or the like.

In addition, the disconnection position detection unit 32 is not limited to the configuration illustrated in Fig. 3 and may be configured as disclosed in, for example, Patent Literatures 4 to 6.

In the configuration disclosed in Patent Literature 4, an assumed propagation time necessary for a signal to propagate through a solar battery string without a failure is stored, and the signal is output to a positive electrode of the solar battery string. Next, on the basis of a time from output of the signal to detection of a reflection signal reflected from the solar battery string, the propagation time of the signal propagating through the solar battery string is measured. Then, on the basis of the measured propagation time and the assumed propagation time, a failure position such as the disconnection of the solar battery string is estimated.

In the configuration disclosed in Patent Literature 5, the failure position due to the disconnection of the solar battery module or the like is estimated from a signal of a reflected wave when a signal is input to the positive electrode of the solar battery module and a signal of a reflected wave when the signal is input to the negative electrode thereof.

In the configuration disclosed in Patent Literature 6, metal frames of first to n^{th} solar battery modules connected in series are electrically connected, one input end of an LCR meter is connected to an open end of the first solar battery module, the other input end of the LCR meter is connected to the metal frame of the first solar battery module, and then a first capacitance is measured. Further, in a state in which any one of the first to n^{th} solar battery modules connected in series is disconnected, a second capacitance is measured in the same manner. Then, the disconnection position is obtained from a ratio between the first capacitance and the second capacitance.

### (Advantages of arc occurrence position detection device 15)

As described above, the arc occurrence position detection device 15 has a configuration in which, when the arc detection unit 31 monitors the presence or absence of the arc and the occurrence of the arc is detected, the disconnection position detection unit 32 specifies the disconnection position of the solar battery string 11 and sets the disconnection position as the arc occurrence position. Therefore, it is possible to appropriately specify the occurrence position of the series arc generated by the disconnection of the cable or the like.

In the above-described embodiment, the case in which the DC power source is the solar battery string 11 has been described. However, the DC power source is not limited to the solar battery string 11, and any DC power source which generates electric power or charges and discharges may be used.

Further, in the above-described embodiment, the case in which the CPU forming the main control unit 33, the CPU 54 of the arc detection unit 31, and the CPU 78 of the disconnection position detection unit 32 are configured with individual CPUs has been described. However, these CPUs may be configured with one CPU or may be configured with two CPUs.

Further, a function of the main control unit 33 may be shared by the CPU (control unit) of the arc detection unit 31 and the CPU 78 (control unit 82) of the disconnection position detection unit 32. In this case, when the occurrence of the arc is detected, the control unit of the arc detection unit 31 displays the fact on the display unit 34 and notifies the management device and the control unit 82 of the disconnection position detection unit 32. The control unit 82 of the disconnection position detection unit 32 controls the opening and closing operation of the arc cutoff switch 12, determines whether the arc is the series arc or the parallel arc and performs the disconnection position detection operation when the arc is the series arc. Also, the detected disconnection position is displayed as the arc occurrence position on the display unit 34, and the management device is notified.

Further, although the output power of the solar battery module is converted to the AC power by the PCS 13 in the above-described embodiment, it may be configured to be connected to a DC load in which the DC power is consumed without the conversion into the AC power in the PCS 13.

As described above, the arc occurrence position detection device according to one aspect of the present invention is an arc detection device applied to a DC power source system which includes a DC power source configured to generate electric power or charge and discharge, a load device configured to convert or consume DC power supplied from the DC power source, and an output line configured to connect the DC power source and the load device, the arc occurrence position detection device including an arc detection unit configured to detect occurrence of an arc at at least one of the DC power source and the output line, a disconnection position detection unit configured to detect a disconnection position at the DC power source, and a control unit configured to operate the disconnection position detection unit when the arc detection unit detects the arc and outputs a disconnection position detected by the disconnection position detection unit as an arc occurrence position.

As a result of intensive research, the inventors of the present application have found that the series arc in the DC power source is frequently caused, for example, by disconnection and separation from a state in which cables are connected and thus the disconnection position can be specified as the arc occurrence position, and have completed the present invention.

According to the above-described configuration, for example, the arc detection unit monitors the DC power source which generates the electric power or discharges and discharges, and detects the occurrence of the arc at at least one of the output line connecting the DC power source and the load device and the DC power source. When the arc detection unit detects the arc, the control unit operates the disconnection position detection unit which detects the disconnection position at the DC power source and outputs the disconnection position detected by the disconnection position detection unit as the arc occurrence position. Accordingly, it is possible to appropriately specify the occurrence position of the series arc generated by the disconnection of the cable or the like in the DC power source.

In the above-described arc occurrence position detection device, an arc cutoff switch of which an opening and closing operation is controlled by the control unit may be provided in the output line, and the control unit may set the arc cutoff switch to be in the open state when the arc detection unit detects the occurrence of the arc, may determine that the arc is a series arc when the arc is extinguished, and may operate the disconnection position detection unit in a state in which the arc cutoff switch is in the open state.

According to the above-described configuration, when the arc detection unit detects the occurrence of the arc, the control unit opens the arc cutoff switch provided in the output line which connects the DC power source and the load device and determines that the arc is the series arc when the arc is extinguished. Then, the control unit operates the disconnection position detection unit while the arc cutoff switch is in the open state. Accordingly, the disconnection position detection unit can detect the disconnection position in the state in which the series arc is extinguished.

The arc occurrence position detection method according to one aspect of the present invention is an arc detection method applied to a DC power source system which includes a DC power source configured to generate electric power or to charge and discharge, a load device configured to convert or consume DC power supplied from the DC power source, and an output line configured to connect the DC power source and the load device, the method including an arc detection process of detecting occurrence of an arc at at least one of the DC power source and the output line, and a disconnection position detection process of detecting a disconnection position at the DC power source when the arc is detected by the arc detection process and setting the detected disconnection position as an arc occurrence position.

According to the above-described configuration, in the arc detection process, the occurrence of the arc at the DC power source which generates the electric power or charges and discharges is detected, and in the disconnection position detection process, when the arc is detected by the arc detection process, the disconnection position at the DC power source is detected, and the detected disconnection position is set as the arc occurrence position. Therefore, it is possible to appropriately specify the occurrence position of the series arc generated by the disconnection of the cable or the like at the DC power source.

The present invention is not limited to the above-described embodiment, and various modifications are possible within the scope indicated in the claims, and also other embodiments obtained by appropriately combining the technical means disclosed in the embodiment are also included in the technical scope of the present invention.

### [Reference Signs List]

1 Photovoltaic power generation system (DC power source system)
11 Solar battery string (DC power source)
12 Arc cutoff switch
13 Power conditioning system (PCS, load device)
15 Arc occurrence position detection device
16a Output line
16b Output line
21 Solar battery module
31 Arc detection unit
32 Disconnection position detection unit
33 Main control unit (control unit)
34 Display unit
41 Current sensor
42 Arc detection processing unit
91 Inspection signal

## Claims

1. An arc occurrence position detection device applied to a DC power source system which includes a DC power source configured to generate electric power or to charge and discharge, a load device configured to convert or consume DC power supplied from the DC power source, and an output line configured to connect the DC power source and the load device, the arc occurrence position detection device comprising:
an arc detection unit configured to detect occurrence of an arc at at least one of the DC power source and the output line,
a disconnection position detection unit configured to detect a disconnection position at the DC power source, and
a control unit configured to operate the disconnection position detection unit when the arc detection unit detects the arc and output the disconnection position detected by the disconnection position detection unit as an arc occurrence position.

2. The arc occurrence position detection device according to claim 1, wherein an arc cutoff switch of which an opening and closing operation is controlled by the control unit is provided in the output line, and
the control unit sets the arc cutoff switch to be in an open state when the arc detection unit detects the occurrence of the arc, determines that the arc is a series arc when the arc is extinguished, and operates the disconnection position detection unit in a state in which the arc cutoff switch is in the open state.

3. An arc occurrence position detection method applied to a DC power source system which comprises a DC power source configured to generate electric power or to charge and discharge, a load device configured to convert or consume DC power supplied from the DC power source, and an output line configured to connect the DC power source and the load device, the method comprising:
an arc detection process of detecting occurrence of an arc at at least one of the DC power source and the output line, and
a disconnection position detection process of detecting a disconnection position at the DC power source when the arc is detected by the arc detection process and setting the detected disconnection position as an arc occurrence position.
